Europäisches Patentamt

European Patent Office

Office européen des brevets

(11) Publication number: **0 074 137**
**B1**

(12) **EUROPEAN PATENT SPECIFICATION**

(45) Date of publication of patent specification: **19.12.84**

(21) Application number: **82201040.1**

(22) Date of filing: **18.08.82**

(51) Int. Cl.³: **H 03 G 5/04,** H 04 R 3/04,
H 03 F 3/183

(54) **Apparatus for electroacoustic energy conversion.**

(30) Priority: **04.09.81 NL 8104108**

(43) Date of publication of application:
**16.03.83 Bulletin 83/11**

(45) Publication of the grant of the patent:
**19.12.84 Bulletin 84/51**

(84) Designated Contracting States:
**AT BE CH DE FR GB IT LI LU NL SE**

(56) References cited:
**US-A-3 646 270**
**US-A-4 052 560**
**US-A-4 071 782**
**US-E- 29 529**

(73) Proprietor: **von Michalofski, Erik**
**Planetenlaan 408**
**NL-3318 JS Dordrecht (NL)**
(73) Proprietor: **van Dijk, Jacobus Cornelis**
**Gouvernestraat 134b**
**Rotterdam (NL)**

(72) Inventor: **von Michalofski, Erik**
**Planetenlaan 408**
**NL-3318 JS Dordrecht (NL)**
Inventor: **van Dijk, Jacobus Cornelis**
**Gouvernestraat 134b**
**Rotterdam (NL)**

(74) Representative: **Kooy, Leendert Willem et al**
**OCTROOIBUREAU VRIESENDORP & GAADE**
**P.O. Box 266**
**NL-2501 AW The Hague (NL)**

Courier Press, Leamington Spa, England.

## Description

The invention relates to an appartus for electroacoustical energy conversion; an input channel for an electrical signal to be converted is series connected to a non-linear signal processing circuit to emphasize the electrical input signal in a frequency range above a predetermined frequency, a power amplifier and an electroacoustical transducer or loudspeaker, wherein the said signal processing circuit comprises an input means including a linear signal divider, a linear channel to carry a first signal fraction of the electrical input signal, a non-linear channel to carry the further signal fraction of the electrical input signal and a signal adding means combining directly the output signals of the said linear channel and the said non-linear channel, said non-linear channel providing a time differentiation of its input signal and subsequently a further non-linear processing of the differentiated signal.

Apparatus of similar type are known to be used for sound reproduction. Shortcomings of known sound reproduction apparatus are attributed to failure of the transducer to convert the applied electrical signal energy faithfully, in particular in the upper audio frequency range. An apparatus in accordance with the precharacterizing part of claim 1 (US—A—4 052 560) seeks to improve on the quality of reproduction by straight-forwardly emphasizing an electrical signal fraction in the upper audio frequency range, up from about 1000 Hz. Emphasis is added in the prior art apparatus by means of the non-linear channel, wherein said further non-linear signal processing comprises raising to a power greater than 1 of the time derivative of the electrical input signal.

Surprisingly it is found that a perceptible elimination of shortcomings in sound reproduction apparatus of the above type is provided in that the non-linear processing in the non-linear channel of the time derivative of the electric input signal comprises a further time differentiation, both differentiating means in the non-linear channel being operative in a frequency range up from about 50 kHz.

It is believed that an electrical drive signal for a loudspeaker that has been emphasized in such a high frequency range, directly activates suprious modes of the loudspeaker driver means which spurious modes are corresponding with harmonics of electrical sound signals to be reproduced. Apparently a substantial portion of the drive energy from the power amplifier is absorbed by these spurious modes. By adding according to the invention energy to specifically saturate any spurious mode the original electrical signal will be fully available for driving the transducer and thus ensure faithful sound reproduction.

In particular the apparatus according to the invention appears to be a hearing aid for persons at and beyond middle age.

These advantages and features of the invention will be further understood from the following description and drawings.

Brief description of the drawings

Fig. 1 is a block-diagram of a preferred embodiment of an apparatus according to the invention.

Fig. 2 is a detailed diagram of the embodiment of the invention as shown in Fig. 1.

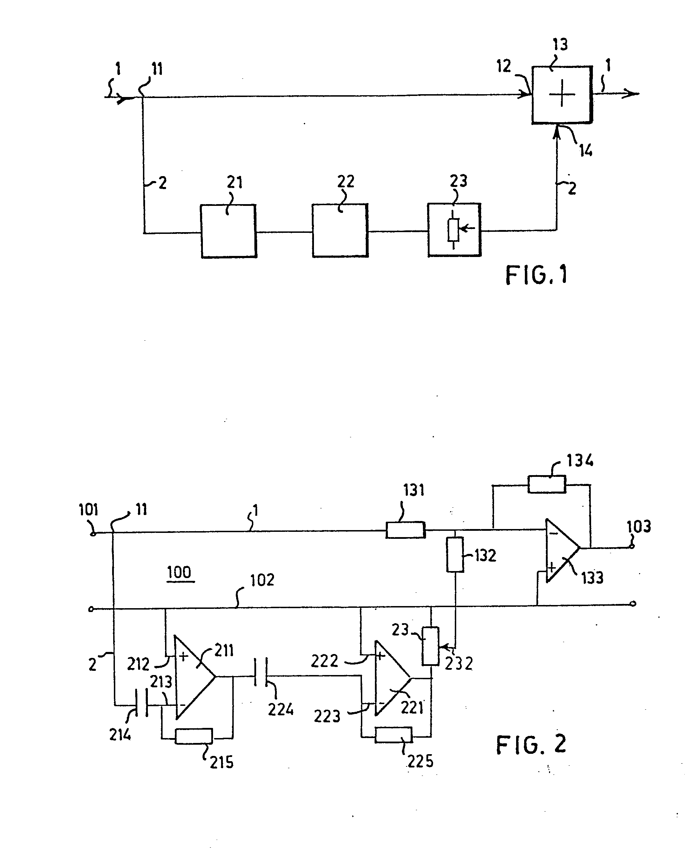

Fig. 1 shows a block-diagram of an apparatus according to the invention. An electrical signal is fed into a channel 1 and subsequently partially branched off into a by-pass channel 2 at an intersection 11. The by-pass channel 2 presents its output signal to an input 14 of an adding circuit 13 in channel 1. A second input 12 is connected to receive a signal from channel 1 downstream from intersection 11. A first active differentiating circuit 21, a second active differentiating circuit 22 and a manually adjustable level control means 23 have been arranged in sequence in the by-pass channel.

In Fig. 2 the basic diagram according to Fig. 1 is shown in detail. A channel 100 for transmitting an electric signal to an electroacoustic transducer, has a 2-wire implementation comprising a signal wire having input 101 and output 103 and a reference wire 102.

A fraction signal wire 2 is branched off downstream of input 101 of signal wire 1 at intersection 11. In fraction signal wire 2 to differentiating active circuits have been arranged in series connection. Each of the differentiating circuits comprises an operational amplifier (211 and 221 respectively), of which one input (212 and 222 respectively) has been connected to the reference wire 102 and the other input (213 and 223 respectively) is receiving the processed signal fraction. The signal fraction from the intersection 11 is fed through a capacitor 214 to the fraction signal input of the operational amplifier 211 and the output signal of the operational amplifier 211 is fed through a capacitor 224 to the fraction signal input of the operational amplifier 221. The output signal of the operational amplifier 211 is, moreover, fed back to its fraction signal input through a resistor 215. Equally the output of the operational amplifier 221 is fed back to its fraction signal input 223 through a resistor 225. The output signal of the operational amplifier 221 is supplied through a potentiometer 23 to an active adding circuit in channel 100 comprising a series resistor 131 in signal wire 1, a resistor 132 connecting signal wire 1 downstream of series resistor 131 with the movable contact 232 of potentiometer 23, an operational amplifier 133 of which one input is connected to reference wire 102 and the other input is receiving the signal downstream of series resistance 131, and a feedback resistor 134 which is on the one hand connected to the output of operational amplifier 133 and on the other hand to the signal carrying input of operational amplifier 133. The output of operational amplifier 133 is at the same time signal wire output 103 leading to an electroacoustic transducer (not shown). Optionally another power amplifier is connected between output 103 of signal adding means 13 and the electroacoustic transducer.

In an embodiment of the invention according to Fig. 2 both resistors 215 and 225 were rated at 100 kohm and both capacitors 214 and 224 were rated at 1.5 pF. The differentiating circuits thus provided signal amplification from the frequency of 100 kHz upwards. When applied in a sound reproduction system its sound output signal appeared to have markedly improved perceptibility.

## Claim

An apparatus for electroacoustical energy conversion in which; an input channel (1) for an electrical signal to be converted is series connected to a non-linear signal processing circuit (Fig. 1) to emphasize the electrical input signal in a frequency range above a predetermined frequency, a power amplifier and an electroacoustical transducer or loudspeaker, wherein the said signal processing circuit comprises an input means including a linear signal divider (11), a linear channel to carry a first signal fraction of the electrical input signal, a non-linear channel (2) to carry the further signal fraction of the electrical input signal and a signal adding means (13) combining directly the output signals of the said linear channel and the said non-linear channel, said non-linear channel providing a time differentiation (21) of its input signal and subsequently a further non-linear processing (22, 23) of the differentiated signal, characterized in that the non-linear processing in the non-linear channel of the time derivative of the electric input signal comprises a further time differentiation (22), both differentiating means (21, 22) in the non-linear channel (2) being operative in a frequency range up from about 50 kHz.

## Revendication

Appareil pour la conversion électro-acoustique d'énergie dans lequel un canal d'entrée (1) de signal électrique à convertir est relié en série avec un circuit non linéaire de traitement de signal (figure 1) pour renforcer le signal électrique d'entrée dans une gamme de fréquence au-dessus d'une fréquence prédéterminée, un amplificateur de puissance et un transducteur électro-acoustique ou hautparleur, dans lequel ledit circuit de traitement du signal comprend des moyens d'entrée comportant un diviseur linéaire de signal (11), un canal linéaire pour transporter une première fraction du signal électrique d'entrée, un canal non linéaire (2) pour porter la fraction supplémentaire du signal électrique d'entrée et un moyen additionneur de signaux (13) combinant directement les signaux de sortie dudit canal linéaire et dudit canal non linéaire, ledit canal non linéaire fournissant une différentiation temporelle (21) de son signal d'entrée et, ensuite, un autre traitement non linéaire (22, 23) du signal différencié, caractérisé en ce que le traitement non linéaire, dans le canal non linéaire, de la dérivée par rapport au temps du signal électrique d'entrée comprend une autre différentiation temporelle (22), deux moyens de différentiation (21, 22) du canal non linéaire (2) étant efficaces dans une gamme de fréquence à partir d'environ 50 kHz.

## Patentanspruch

Apparat zur elektroakustischen Umsetzung von Energie, in welchem ein Eingangskanal (1) für ein umzusetzendes elektrisches Signal in Reihe mit einem nichtlinearen Signalverarbeitungskreis (Fig. 1) geschaltet ist, um das elektrische Eingangssignal in einem Frequenzbereich oberhalb einer vorgegebenen Frequenz anzuheben, mit einem Leistungsverstärker und einem elektroakustischen Signalumformer oder Lautsprecher, worin der genannte Signalverarbeitungskreis mit einer Eingangs- bzw. Eingabeeinrichtung versehen ist, die einen linearen Signalteiler (11), einen linearen Kanal, um ein erstes Teil- bzw. Bruchteil-Signal des elektrischen Eingangssignals weiterzuleiten, einen nichtlinearen Kanal (2), um das verbleibende Teil-Signal des elektrischen Eingangssignals weiterzuleiten und eine Signaladdiereinrichtung (13) besitzt, welche direkt die Ausgangssignale des genannten linearen Kanals und des genannten nichtlinearen Kanals kombiniert, wobei der nichtlineare Kanal eine Zeitdifferenzierung (21) seines Eingangssignals und darauf eine nichtlineare Verarbeitung (22, 23) des differenzierten Signals vorsieht, dadurch gekennzeichnet, daß die nichtlineare Verarbeitung im nichtlinearen Kanal Zeitderivates des elektrischen Eingangssignals eine weitere Zeitdifferenzierung (22) umfaßt, und daß beide Differenzierungseinrichtungen (21, 22) im nichtlinearen Kanal (2) in einem Frequenzbereich ab etwa 50 kHz betrieben werden können.

FIG.1

FIG. 2